# EUROPÄISCHE PATENTSCHRIFT

(11) **EP 3 993 265 B1**
(45) Veröffentlichungstag und Bekanntmachung des Hinweises auf die Patenterteilung: **05.08.2026**
(21) Anmeldenummer: 20465573.2
(22) Anmeldetag: 27.10.2020
(51) Int. Cl.: H03K 17/16

(54) **VERFAHREN ZUM SCHALTEN VON LEISTUNGSTRANSISTOREN**
METHOD FOR SWITCHING POWER TRANSISTORS
PROCÉDÉ DE COMMUTATION DES TRANSISTORS DE PUISSANCE

(43) Veröffentlichungstag der Anmeldung: 04.05.2022
(73) Patentinhaber: Schaeffler Technologies AG & Co. KG, 91074 Herzogenaurach (DE)
(72) Erfinder: Loerincz, Robert Istvan, 81737 München (DE); Antongirolami, Diego, 81737 München (DE); Arabackyj, Marc, 81737 München (DE); Maser, Matthias, 81737 München (DE); Taistra, Eric, 81737 München (DE); Joseph, Sahaya Kulandai Raj, 81737 München (DE)
(74) Vertreter: Schaeffler Technologies

(56) Entgegenhaltungen:
- US-A1- 2019 229 723
- SALVATORE MUSUMECI ET AL: "Switching-Behavior Improvement of Insulated Gate-Controlled Devices are with the SGS-Thomson Co", 4 July 1997 (1997-07-04), XP055210648, Retrieved from the Internet <URL:http://ieeexplore.ieee.org/ielx3/63/13230/00602559.pdf?tp=&arnumber=602559&isnumber=13230> [retrieved on 20150901]

## Beschreibung

Bei vielen Anwendungen wie zum Beispiel bürstenlosen Gleichstrommotoren und DC/DC-Wandlern werden Leistungs-MOSFETs als Schalter verwendet, um induktive Lasten zu betreiben. In solchen Anwendungen ist das Schalten der MOSFETs normalerweise von Bedeutung für die elektromagnetische Verträglichkeit.

Bei jeder Umschaltung eines der MOSFETs wird infolge parasitärer reaktiver Komponenten ein Schwingkreis angeregt, der in den Strömen und Spannungen am MOSFET Schwingungen (Überschwingen) auslöst. Das Überschwingen kann galvanisch weitergeleitete oder abgestrahlte Emissionen verursachen, die die Grenzen der elektromagnetischen Verträglichkeit überschreiten.

Aus der WO 2014/173969 A1 ist ein Verfahren zum mittels eines Pulsweitenmodulationssignals gesteuerten Einschalten oder Abschalten eines elektronischen Bauelements bekannt, das zur Ausgabe eines mittels eines Steuersignals steuerbaren Ausgabesignals ausgebildet ist. Das Ein- oder Abschalten wird innerhalb einer Pulsweitenmodulationstaktperiode zu einem Pegelwechselzeitpunkt durch eine Änderung des Pulsweitenmodulationssignals initiiert. Es werden wenigstens ein erster Steuerwert und ein zweiter Steuerwert des Steuersignals vorgegeben und das Steuersignal wird innerhalb jeder Pulsweitenmodulationstaktperiode zwischen dem Pegelwechselzeitpunkt und einem ersten Umschaltzeitpunkt auf den ersten Steuerwert, zwischen dem ersten Umschaltzeitpunkt und einem zweiten Umschaltzeitpunkt auf den zweiten Steuerwert und ab dem zweiten Umschaltzeitpunkt bis zum Erreichen eines Gatespannungsendwertes am Gate des elektronischen Bauelements auf einen dritten Steuerwert eingestellt. Jeder Umschaltzeitpunkt einer Pulsweitenmodulationstaktperiode wird in Abhängigkeit von einer während einer vorangehenden Pulsweitenmodulationstaktperiode ermittelten Amplitudengröße derart bestimmt, dass Schwingungsamplituden der Oszillation des Ausgabesignals begrenzt werden.

Ein Verfahren zum Schalten von Leistungstransistoren in einer Leistungstransistorschaltung aus dem Stand der technik ist beispielsweise auch aus der US 2019/229723 A1 bekannt.

Der Erfindung liegt die Aufgabe zu Grunde, ein verbessertes Verfahren zum Schalten von Leistungstransistoren anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei einem erfindungsgemäßen Verfahren zum Schalten von Leistungstransistoren in einer Leistungstransistorschaltung, wobei die Leistungstransistoren jeweils ein Gate aufweisen, wird das Gate bei einer Einschaltsequenz und/oder einer Ausschaltsequenz sequentiell mit mindestens drei Steuerwerten angesteuert, zwischen denen zu bestimmten Zeitpunkten umgeschaltet wird. Erfindungsgemäß werden die Zeitpunkte mittels eines Reglers bestimmt oder modifiziert, der von einem Millerplateau-Detektor zur Detektion eines Millerplateaus in einer Gate-Source-Spannung des jeweiligen Leistungstransistors angesteuert wird. Die mindestens drei Steuerwerte können voneinander und/oder von Null verschieden sein, können aber auch teilweise übereinstimmen. Beispielsweise können der erste Steuerwert und der dritte Steuerwert gleich sein.

Erfindungsgemäß findet beim Einschalten der Wechsel von einem ersten Steuerwert zu einem zweiten Steuerwert um eine Zeitdifferenz vor dem Beginn des Millerplateaus statt und/oder findet der Wechsel vom zweiten Steuerwert zu einem dritten Steuerwert beim Einschalten um eine Zeitdifferenz nach dem Beginn des Millerplateaus statt und/oder findet beim Ausschalten der Wechsel vom ersten Steuerwert zum zweiten Steuerwert um eine Zeitdifferenz nach dem Erreichen des Millerplateaus statt und/oder findet beim Ausschalten der Wechsel vom zweiten Steuerwert zum dritten Steuerwert um eine Zeitdifferenz nach dem Erreichen des Millerplateaus statt. Der zweite Steuerwert wird während des Einschaltens und Ausschaltens des Leistungstransistors in Abhängigkeit von einem Pegel eines Laststroms angepasst.

In einer Ausführungsform wird dem Millerplateau-Detektor eine Phasenspannung einer Halbbrücke, die Teil der Leistungstransistorschaltung ist, oder irgendeine Spannung oder irgendein Strom dieser Halbbrücke, beispielsweise eine Drain-Source-Spannung oder eine Gate-Source-Spannung, zur Detektion des Millerplateaus zugeführt. Der Millerplateau-Detektor kann ebenso auf der Detektion von Spannungstransienten an einem Source-Anschluss eines Leistungstransistors im unteren Brückenzweig dieser Halbbrücke oder auf der Detektion von Überschwingen basieren.

In einer Ausführungsform wird mittels des Millerplateau-Detektors detektiert, wann das Millerplateau beginnt oder wann das Millerplateau beginnt und endet.

In einer Ausführungsform wird das Millerplateau in jedem Arbeitszyklus detektiert, in dem der jeweilige Leistungstransistor nicht freilaufend ist, wobei diese Information verwendet wird, um die Zeitpunkte für den nächsten Arbeitszyklus anzupassen, in dem der jeweilige Leistungstransistor nicht freilaufend ist.

Der Leistungstransistor, insbesondere MOSFET, wird in der vorliegenden Anmeldung als freilaufend bezeichnet, wenn der Leistungstransistor (wenn der Leistungstransistor durchgeschaltet ist) oder eine Body-Diode (wenn der Leistungstransistor nicht durchgeschaltet ist) des Leistungstransistors einen Freilaufstrom einer induktiven Last trägt.

In einer Ausführungsform wird das Millerplateau mittels eines im Millerplateau-Detektor enthaltenen Komparators anhand der Phasenspannung detektiert.

Erfindungsgemäß findet beim Einschalten der Wechsel von einem ersten Steuerwert, beispielsweise an einem Gate des Leistungstransistors, insbesondere MOSFETs, zu einem zweiten Steuerwert um eine Zeitdifferenz vor dem Beginn des Millerplateaus statt und/oder der Wechsel vom zweiten Steuerwert zu einem dritten Steuerwert findet beim Einschalten um eine Zeitdifferenz nach dem Beginn des Millerplateaus statt und/oder beim Ausschalten findet der Wechsel vom ersten Steuerwert zum zweiten Steuerwert um eine Zeitdifferenz nach dem Erreichen des Millerplateaus statt und/oder beim Ausschalten findet der Wechsel vom zweiten Steuerwert zum dritten Steuerwert um eine Zeitdifferenz nach dem Erreichen des Millerplateaus statt

Erfindungsgemäß wird der zweite Steuerwert während des Einschaltens und Ausschaltens des Leistungstransistors in Abhängigkeit von einem Pegel eines Laststroms angepasst.

In einer Ausführungsform erfolgt die Ansteuerung mit mindestens drei Steuerwerten nur für nicht freilaufende Leistungstransistoren in der Leistungstransistorschaltung, während freilaufende Leistungstransistoren mit einem konstanten Steuerwert angesteuert werden.

In einer Ausführungsform wird zur Detektion, ob ein Leistungstransistor in einer Halbbrücke im nächsten Arbeitszyklus freilaufend ist, während einer Totzeit, während der beide Leistungstransistoren der Halbbrücke ausgeschaltet sind, die Phasenspannung gemessen, wobei dann, wenn die Phasenspannung niedrig ist, der Leistungstransistor in einem unteren Zweig der Halbbrücke als im nächsten Arbeitszyklus freilaufend erkannt wird.

In einer Ausführungsform wird in einer Leistungstransistorschaltung mit mindestens zwei Halbbrücken ein Leistungstransistor, der zum Einschalten mit mindestens drei verschiedenen Steuerwerten angesteuert wurde, grundsätzlich auch zum Ausschalten im gleichen Arbeitszyklus mit mindestens drei verschiedenen Steuerwerten angesteuert, und ein Leistungstransistor, der zum Einschalten mit einem konstanten Steuerwert angesteuert wurde, wird grundsätzlich auch zum Ausschalten im gleichen Arbeitszyklus mit konstanten Steuerwert angesteuert, außer wenn ein langer Impuls detektiert wird, der eine Änderung in der Polarität des Phasenstroms der jeweiligen Halbbrücke verursacht.

In einer Ausführungsform wird zum Ermitteln eines langen Impulses beim Einschalten eines Leistungstransistors in einer der Halbbrücken ein Zähler gestartet, dessen Zählerstand jedes Mal, wenn ein neuer Arbeitszyklus auf eine der anderen Halbbrücken angewandt wird, um eins erhöht wird, wobei dann, wenn der Zähler einen bestimmten Wert erreicht hat, das Abschalten des Leistungstransistors unter Verwendung mindestens dreier unterschiedlicher Steuerwerte durchgeführt wird.

In einer Ausführungsform werden die Zeitpunkte und/oder mindestens ein Zielwert mindestens einer der Zeitdifferenzen in Abhängigkeit vom Laststrom variiert.

In einer Ausführungsform wird bei der Verwendung von mindestens drei Steuerwerten der zweite Steuerwert während des Einschaltens und Ausschaltens des Leistungstransistors entsprechend dem Pegel des Laststroms angepasst. Bei Verwendung von drei oder mehr Steuerwerten kann derjenige Steuerwert angepasst werden, der am Ende des Millerplateaus angewandt wird.

In einer Ausführungsform werden die Steuerwerte mittels einer vom Regler angesteuerten Quelle eingestellt, die in einem Stromquellenmodus betrieben wird, wobei die Quelle am Ende der Einschaltsequenz und/oder der Ausschaltsequenz vom Stromquellenmodus in einen Spannungsquellenmodus umgeschaltet wird.

In einer Ausführungsform wird das Ende der Einschaltsequenz und/oder der Ausschaltsequenz mittels
- eines Zeitgebers, der am Beginn des Millerplateaus ausgelöst wird, oder
- eines Komparators für die Gate-Source-Spannung
detektiert.

Die gemäß der vorliegenden Erfindung vorgeschlagene Betriebsstrategie für MOSFETs ermöglicht das Schalten der MOSFETs und die Verringerung von Leistungsverlusten ohne erhöhte elektromagnetische Emissionen zu verursachen. Dies wird durch spezielle in einem integrierten Schaltkreis, beispielsweise einem ASIC oder ASSP, implementierte Merkmale und ohne zusätzliche externe Komponenten erzielt, so dass Kosten und Platzbedarf reduziert werden und durch externe Komponenten verursachte zusätzliche Schaltverluste vermieden werden, da diese das gesamte Schalten verzögern. Externe Komponenten müssen für den schlechtesten Fall (worst case) dimensioniert sein und erhöhen die Schaltzeiten.

Anders als im Stand der Technik wird gemäß der vorliegenden Erfindung kein Überschwingdetektor mit den damit verbundenen Layoutbeschränkungen und hochauflösenden Zeitgebern benötigt.

Ausführungsbeispiele der Erfindung werden im Folgenden anhand von Zeichnungen näher erläutert.

Dabei zeigen:
- Figur 1: ein schematisches Schaltbild einer Leistungstransistorschaltung aus Leistungstransistoren zum Betrieb einer Last,
- Figur 2: ein schematisches Schaltbild einer vereinfachten Halbbrücke,
- Figur 3: schematische Diagramme einer Phasenspannung über der Zeit beim Schalten von MOSFETs,
- Figur 4: ein schematisches Diagramm einer Gate-Source-Spannung eines MOSFET über der Zeit beim Schalten, wobei eine Totzeit sicherstellt, dass ein MOSFET in einem oberen Brückenzweig niemals gleichzeitig mit einem MOSFET in einem unteren Brückenzweig eingeschaltet ist,
- Figur 5: ein schematisches Diagramm einer Schaltsequenz der Halbbrücke bei freilaufendem MOSFET, das heißt während des Fließens eines Freilaufstroms durch das MOSFET im unteren Brückenzweig,
- Figur 6: ein schematisches Diagramm einer Schaltsequenz der Halbbrücke bei freilaufendem MOSFET, das heißt während des Fließens eines Freilaufstroms durch das MOSFET im oberen Brückenzweig,
- Figur 7: ein schematisches Schaltbild einer Brückenschaltung zum Betrieb eines dreiphasigen Elektromotors und ein schematisches Diagramm,
- Figur 8: ein schematisches Diagramm mit einer Schaltsequenz eines MOSFET,
- Figur 9: ein schematisches Diagramm mit einer Schaltsequenz eines MOSFET,
- Figur 10: eine schematische Ansicht eines Algorithmus zur Ermittlung, welcher MOSFET einer Halbbrücke freilaufend ist, das heißt, durch welches MOSFET der Freilaufstrom fließt,
- Figur 11: eine schematische Ansicht einer Zustandsmaschine des MOSFETS für die Anpassung der Zeitpunkte für das Einschalten und für das Ausschalten, wenn der jeweilige MOSFET mit mindestens drei Stromwerten betrieben wird,
- Figur 12: schematische Diagramme zur Darstellung des Zusammenhangs eines Drainstroms mit einer Spannung eines Millerplateaus,
- Figur 13: ein schematisches Diagramm zur Darstellung eines Verhältnisses zwischen einem Laststrom und einem Zeitpunkt zum Umschalten eines Stromwerts,
- Figur 14: schematische Diagramme einer Einschaltsequenz und einer Ausschaltsequenz eines MOSFET,
- Figur 15: ein schematisches Diagramm eines zweiten Stromwertes eines Gatestroms in Abhängigkeit von einem Laststrom,
- Figur 16: ein schematisches Diagramm eines gewünschten Wertes einer Zeitdifferenz in Abhängigkeit vom Laststrom,
- Figur 17: ein schematisches Diagramm zur Darstellung des Überschwingverhaltens für verschiedene zweite Stromwerte des Gatestroms, und
- Figur 18: ein schematisches Diagramm zur Darstellung des Verlustverhaltens für verschiedene zweite Stromwerte des Gatestroms.

Einander entsprechende Teile sind in allen Figuren mit den gleichen Bezugszeichen versehen.

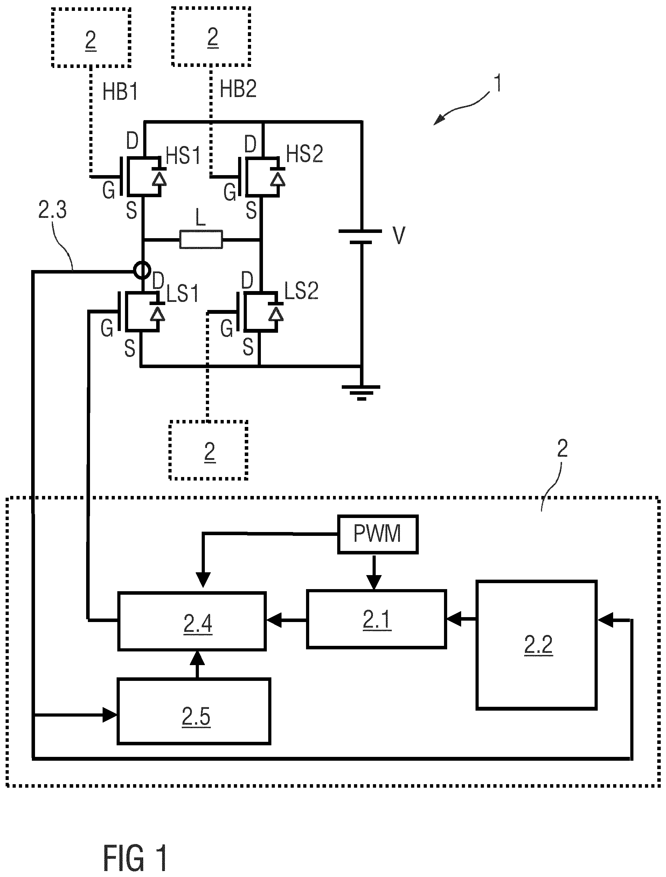

Figur 1 ist ein schematisches Schaltbild einer Leistungstransistorschaltung, insbesondere einer Brückenschaltung 1, aus Leistungstransistoren zum Betrieb einer Last L, beispielsweise MOSFETs HS1, HS2, LS1, LS2 oder IGBT, auf die im Folgenden als MOSFETs HS1, HS2, LS1, LS2 Bezug genommen wird. Die Brückenschaltung 1 ist an einer Spannungsquelle V angeschlossen. Jeder der MOSFETs HS1, HS2, LS1, LS2 weist Gate G, Drain D und Source S auf, wobei das Gate G mittels einer Gatetreiberschaltung 2 steuerbar ist, die ein pulsweitenmoduliertes Signal PWM an das Gate G anlegt. Die Gatetreiberschaltung 2 für den MOSFET LS1 ist im Detail dargestellt. Die anderen Gatetreiberschaltungen 2 können auf gleiche Weise gebildet sein. Ebenso kann ein und dieselbe Gatetreiberschaltung 2 die Gates G aller MOSFETs HS1, HS2, LS1, LS2 der Brückenschaltung 1 übernehmen. Die MOSFETs HS1, HS2, LS1, LS2 sind in zwei Halbbrücken HB1, HB2 angeordnet, wobei die MOSFETs HS1, LS1 der Halbbrücke HB1 und die MOSFETs HS2, LS2 der Halbbrücke HB2 zugeordnet sind. Ferner kann in der Gatetreiberschaltung 2 ein weiterer Detektor 2.5 vorgesehen sein, der dazu konfiguriert ist zu detektieren, ob der Schaltzyklus beendet ist, das heißt ob der MOSFET HS1, HS2, LS1, LS2 vollständig ausgeschaltet ist. Dies kann beispielsweise durch Überwachung der Gate-Source-Spannung V_{GS} (unter einem ersten Schwellwert bedeutet ausgeschaltet, über einem zweiten Schwellwert bedeutet eingeschaltet) oder einer Drain-Source-Spannung V_{DS} (Spannungsabfall über Drain/Source ist unterhalb eines Schwellwerts bedeutet vollständig eingeschaltet) erfolgen.

Eine mittels Pulsweitenmodulation gesteuerte Brückenschaltung 1 aus MOSFETs HS1, HS2, LS1, LS2, beispielsweise eine H-Brücke, eine Halbbrücke HB1, HB2 oder andere Konfigurationen können in verschiedenen Anwendungen eingesetzt werden, beispielsweise in Motortreiberschaltungen oder Invertern. Die MOSFETs HS1, HS2, LS1, LS2 werden mittels eines pulsweitenmodulierten Signals gesteuert um einen gewünschten Spannungs- und/oder Stromverlauf an die Last L anzulegen.

Bei jeder Umschaltung eines der MOSFETs HS1, HS2, LS1, LS2 wird infolge parasitärer reaktiver Komponenten ein Schwingkreis angeregt, der in den Strömen und Spannungen am MOSFET HS1, HS2, LS1, LS2 Schwingungen (Überschwingen) auslöst. Das Überschwingen kann galvanisch weitergeleitete oder abgestrahlte Emissionen verursachen, die die Grenzen der elektromagnetischen Verträglichkeit überschreiten.

Die Erfindung ermöglicht die Beschränkung der Emissionen und die Minimierung der Schaltzeit durch entsprechendes Formen eines Gatestroms I_{g} des MOSFET HS1, HS2, LS1, LS2 während einer Ein/Ausschalt-Sequenz des MOSFET HS1, HS2, LS1, LS2.

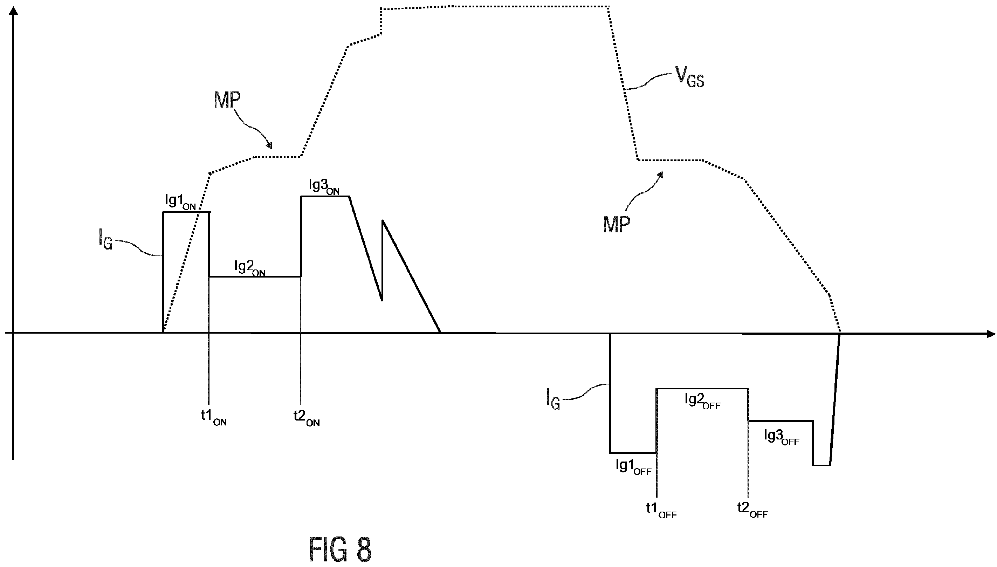

Figur 8 zeigt ein schematisches Diagramm mit einer Schaltsequenz eines MOSFET HS, LS.

Während einer Einschaltsequenz, wie in Figur 8 gezeigt, beginnt der Gatestrom I_{g} mit einem hohen Stromwert Ig1_{ON}, zu einem Zeitpunkt t1_{ON} wird er auf einen niedrigeren Stromwert Ig2_{ON} geschaltet und zu einem Zeitpunkt t2_{ON} wird er wieder auf einen hohen Stromwert Ig3_{ON} geschaltet, der nicht mit dem Stromwert Ig1_{ON} identisch sein muss, jedoch sein kann. Die Stromwerte Ig1_{ON}, Ig2_{ON}, Ig3_{ON} sind vordefinierte Werte. Hingegen werden die Zeitpunkte t1_{ON} und t2_{ON} durch die Gatetreiberschaltung 2 mittels eines Reglers 2.1 ermittelt, der von einem Millerplateau-Detektor 2.2 zur Detektion eines Millerplateaus MP angesteuert wird. Der Regler 2.1 steuert eine Quelle 2.4 an, die den Gatestrom I_{g} festlegt. Während einer Ausschaltsequenz beginnt der Gatestrom I_{g} mit einem hohen Stromwert Ig1_{OFF}, zu einem Zeitpunkt t1_{OFF} wird er auf einen niedrigeren Stromwert Ig2_{OFF} geschaltet und zu einem Zeitpunkt t2_{OFF} wird er wieder auf einen hohen Stromwert Ig3_{OFF} geschaltet, der nicht mit dem Stromwert Ig1_{OFF} identisch sein muss. Die Stromwerte Ig1_{OFF}, Ig2_{OFF}, Ig3_{OFF} sind vordefinierte Werte. Hingegen werden die Zeitpunkte t1_{OFF} und t2_{OFF} durch die Gatetreiberschaltung 2 mittels eines Reglers 2.1 ermittelt, der von einem Millerplateau-Detektor 2.2 zur Detektion eines Millerplateaus MP angesteuert wird. Die Regelung wird über mehrere Arbeitszyklen der Pulsweitenmodulation ausgeführt. Die Gatetreiberschaltung 2 weist einen Messanschluss 2.3 auf, mittels dessen eine Phasenspannung V_{PHASE} der jeweiligen Halbbrücke HB1, HB2 messbar und dem Millerplateau-Detektor 2.2 zuführbar ist. In alternativen Ausführungsformen kann durch den Messanschluss 2.3 irgendein Strom oder irgendeine Spannung der Halbbrücke HB1, HB2 gemessen werden. Ein weiteres Beispiel ist ein Spitzenwert-Detektor, der Spannungstransienten am Source-Anschluss des MOSFET LS im unteren Brückenzweig überwacht.

Statt der Stromwerte können auch Gatespannungsänderungsraten als Steuerwerte verwendet werden.

Das Verfahren erlaubt auch die Anpassung des Stromwerts Ig2 anhand des Laststroms und kann daher das Gatestromprofil besser an den Schaltprozess anpassen.

In synchronen DC/DC-Wandlern oder in Motortreiberschaltungen verursacht nicht jeder Schaltvorgang Emissionen, die für die elektromagnetische Verträglichkeit relevant sind. Beispielsweise sind freilaufende MOSFETs HS, LS normalerweise unkritisch bezüglich der elektromagnetischen Verträglichkeit. Die Erfindung beschreibt eine Möglichkeit, MOSFETs HS, LS zu detektieren, die bezüglich der elektromagnetischen Verträglichkeit kritisch sind, und das beschriebene Verfahren zur Formung des Gatestroms I_{g} nur auf diese MOSFETs HS, LS anzuwenden. Freilaufende MOSFETs HS, LS können stattdessen mit einem konstanten Gatestrom I_{g} betrieben werden.

Der Regelkreis basiert auf der Detektion des Millerplateaus MP. Bei vielen Anwendungen ist der Parameter mit der höchsten Dynamik, der das Millerplateau MP beeinflusst, der Laststrom I_{LOAD}, das heißt bei Motortreiberschaltungen der Phasenstrom I_{PHASE}. Es kann vorkommen, dass ein Regler 2.1 zu langsam ist, um den Fluktuationen des Laststroms I_{LOAD} zu folgen. Die Erfindung beschreibt daher eine Möglichkeit, die Genauigkeit der Regelung für den Fall schneller, dynamischer Ausgangsströme zu verbessern, um für die elektromagnetische Verträglichkeit relevante Emissionen weiter zu reduzieren. In einer Ausführungsform ist der Regler 2.1 als I-Regler ausgebildet.

Reale Stromquellen können den gewünschten Strom nicht über den gesamten Spannungsbereich liefern. Aus diesem Grund ist es im Stand der Technik nicht möglich, die gewünschte Gate-Source-Spannung V_{GS} am Ende der Einschaltsequenz und der Ausschaltsequenz zu erreichen. Die Erfindung beschreibt eine Möglichkeit, die gewünschte Gate-Source-Spannung V_{GS} zu erreichen ohne die elektromagnetische Verträglichkeit zu beeinträchtigen.

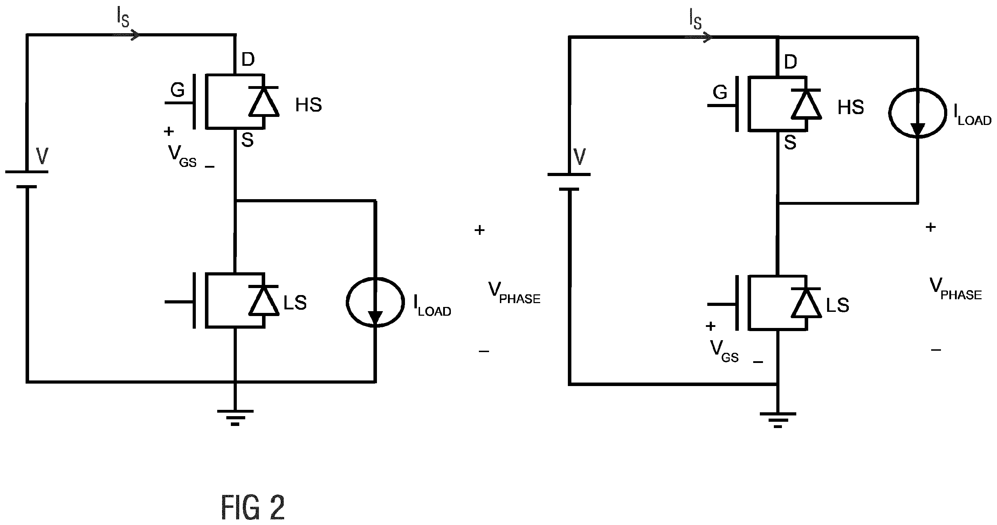

Figur 2 zeigt ein schematisches Schaltbild einer vereinfachten Halbbrücke HB1. Halbbrücken HB1, HB2 zum Betrieb einer induktiven Last L, beispielsweise DC/DC-Wandler, H-Brücken-Motortreiberschaltungen oder B6-Motortreiberschaltungen, können, wie in Figur 2 gezeigt, vereinfacht werden. In einigen Anwendungen, wie zum Beispiel Einquadranten-DC/DC-Wandlern, hat der Laststrom I_{LOAD} immer die gleiche Polarität. In anderen Anwendungen, wie zum Beispiel Motortreiberschaltungen, kann die Polarität des Laststroms I_{LOAD} sich über die Zeit ändern.

Wenn der Laststrom I_{LOAD} positiv ist wie in Figur 2 links dargestellt, verursacht das Schalten des MOSFET HS im oberen Brückenzweig eine schnelle Änderung des Versorgungsstroms Is und in der Phasenspannung V_{PHASE} und löst Überschwingen aus. In diesem Fall ist der MOSFET LS im unteren Brückenzweig im Freilaufpfad und das Schalten des MOSFET LS verursacht keinerlei Überschwingen, keinerlei Veränderung im Versorgungsstrom Is und nur eine geringe Änderung in der Phasenspannung V_{PHASE}.

Wenn der Laststrom I_{LOAD} negativ ist wie in Figur 2 rechts dargestellt, verursacht das Schalten des MOSFET LS im unteren Brückenzweig eine schnelle Änderung des Versorgungsstroms und in der Phasenspannung V_{PHASE} und löst Überschwingen aus. In diesem Fall ist der MOSFET HS im oberen Brückenzweig freilaufend und das Schalten des MOSFET HS verursacht keinerlei Überschwingen, keinerlei Veränderung im Versorgungsstrom und nur eine geringe Änderung in der Phasenspannung V_{PHASE}.

Überschwingen und schnelle Änderungen im Versorgungsstrom und in der Phasenspannung V_{PHASE} verursachen normalerweise Überschreitungen der galvanisch weitergeleiteten oder abgestrahlten Emissionen bezüglich der Spezifikationen der elektromagnetischen Verträglichkeit. Überschwingen und schnelle Änderungen im Versorgungsstrom Is und in der Phasenspannung V_{PHASE} können reduziert werden, indem der verursachende MOSFET HS, LS, das heißt der MOSFET HS bei positivem Laststrom I_{LOAD} und der der MOSFET LS bei negativem Laststrom I_{LOAD}, entsprechend angesteuert wird.

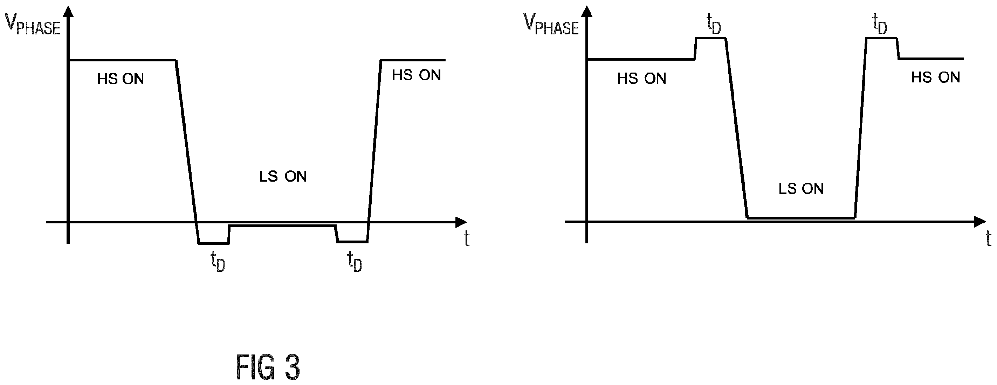

Um einen Kurzschluss zu vermeiden ist immer eine Totzeit t_{d} vorgesehen, während der beide MOSFETs HS, LS der Halbbrücke HB1 ausgeschaltet sind. Während der Totzeit t_{d} fließt der Laststrom I_{LOAD} in der Body-Diode des MOSFET HS, LS. Wenn der Laststrom I_{LOAD} positiv ist fließt er in der Body-Diode des MOSFET LS. Wenn der Laststrom I_{LOAD} negativ ist fließt er in der Body-Diode des MOSFET HS. Deshalb ist während der Totzeit t_{d} die Phasenspannung V_{PHASE} niedrig, wenn der Phasenstrom I_{PHASE} positiv ist, und die Phasenspannung V_{PHASE} ist hoch, wenn der Phasenstrom I_{PHASE} negativ ist, wie in Figur 3 gezeigt. Figur 3 zeigt schematische Diagramme der Phasenspannung V_{PHASE} über der Zeit t beim Schalten des MOSFETs HS, LS, wobei ein Schaltzustand HS ON den eingeschalteten MOSFET HS im oberen Brückenzweig symbolisiert und LS ON den eingeschalteten MOSFET LS im unteren Brückenzweig symbolisiert.

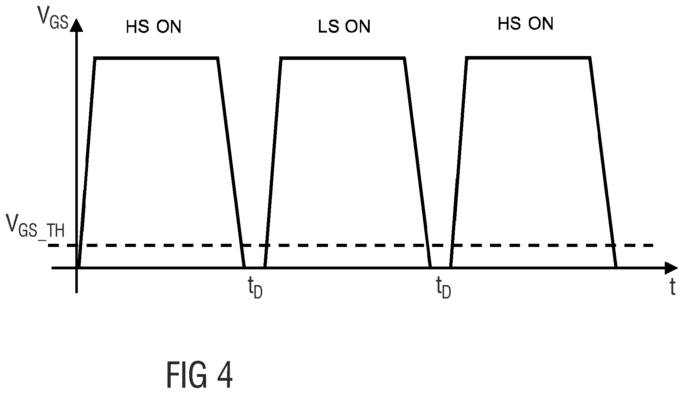

Die Vorrichtung, in der die vorliegende Erfindung implementiert ist, das heißt die Gatetreiberschaltung 2, kann detektieren, ob beide MOSFETs HS, LS ausgeschaltet sind, und die Phasenspannung V_{PHASE} während der Totzeit t_{d} messen. Eine Möglichkeit zu detektieren, dass beide MOSFETS HS, LS ausgeschaltet sind, ist zu überprüfen, wann die beiden Gate-Source-Spannungen V_{GS} beider MOSFETs HS, LS gleichzeitig unterhalb eines Schwellwerts V_{GS_TH} liegen wie in Figur 4 gezeigt ist. Figur 4 zeigt ein schematisches Diagramm der Gate-Source-Spannung V_{GS} eines MOSFET HS, LS über der Zeit t beim Schalten des MOSFETs HS, LS.

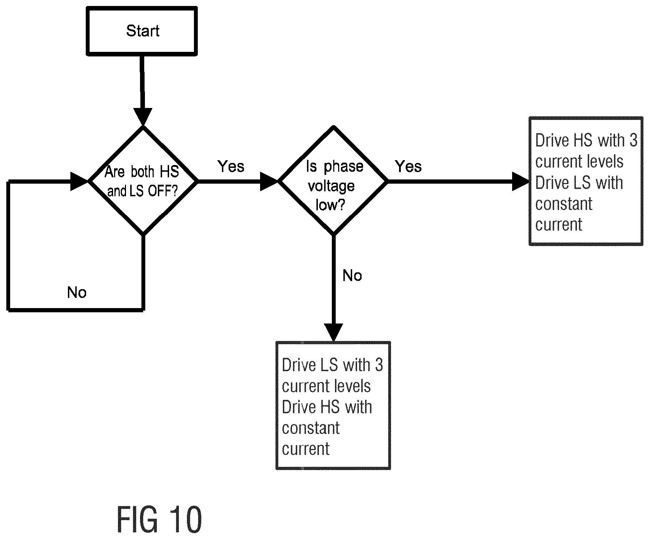

Die Messung der Phasenspannung V_{PHASE} wird dann verwendet um zu detektieren, ob der nächste einzuschaltende MOSFET freilaufend ist oder nicht wie im in Figur 10 dargestellten Algorithmus gezeigt wird. Wenn die Phasenspannung V_{PHASE} niedrig ist, dann wird der MOSFET HS im oberen Zweig der Halbbrücke HB1 bis HB3 als nächstes mit mindestens drei verschiedenen Stromwerten Ig1, Ig2, Ig3 betrieben. Anderen falls wird der MOSFET LS im unteren Zweig der Halbbrücke HB1 bis HB3 als nächstes mit mindestens drei verschiedenen Stromwerten Ig1, Ig2, Ig3 betrieben. Die Höhe der Phasenspannung V_{PHASE} kann mit einem Hysteresekomparator ermittelt werden. Beispielsweise wird die Phasenspannung V_{PHASE} als niedrig erachtet, wenn sie unter 25% eines festgelegten Werts liegt, und als hoch erachtet, wenn sie über 75% des festgelegten Werts liegt. Jede Halbbrücke HB1 bis HB3 hat ihre eigene Phasenspannung V_{PHASE} und der Zustand dieser Phasenspannung V_{PHASE} während der Totzeit t_{D} bestimmt, wie die MOSFETs HS, LS dieser Halbbrücke HB1 bis HB3 gesteuert werden. Es können ein oder mehrere Halbbrücken HB1 bis HB3 vorgesehen sein. Es können drei oder mehr Stromwerte Ig1, Ig2, Ig3 zur Steuerung des Gates G vorgesehen sein.

Figur 10 zeigt eine schematische Ansicht eines Algorithmus zur Ermittlung, welcher MOSFET HS, LS einer Halbbrücke HB1, HB2 freilaufend ist.

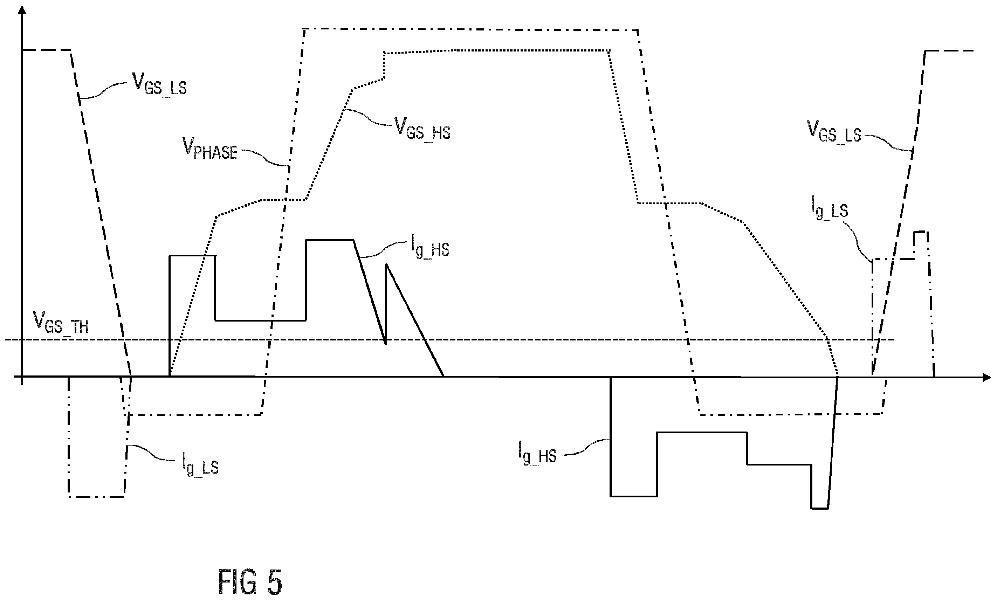

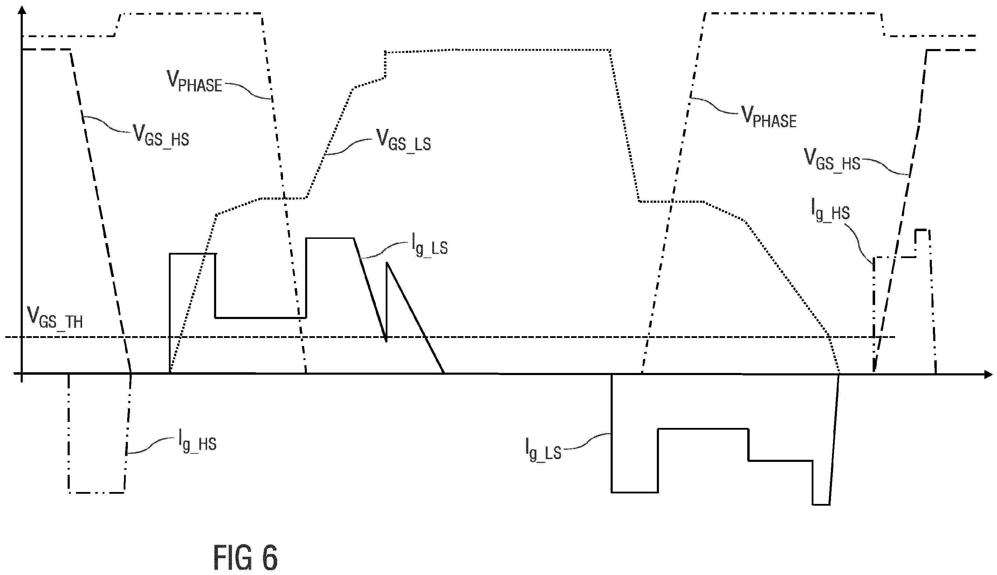

Falls der nächste anzusteuernde MOSFET HS, LS freilaufend ist, wird er mit einem konstanten Gatestrom I_{g} angesteuert. Anderenfalls wird er während des Schaltens unter Verwendung mindestens dreier unterschiedlicher Stromwerte Ig1, Ig2, Ig3 angesteuert, wie in WO2014/173969 A1 beschrieben und in Figur 5 für den freilaufenden MOSFET LS und Figur 6 für den freilaufenden MOSFET HS gezeigt ist.

Figur 5 zeigt ein schematisches Diagramm einer Schaltsequenz der Halbbrücke HB1 bei freilaufendem MOSFET LS, wobei eine Gate-Source-Spannung V_{GS_LS} des MOSFET LS, eine Gate-Source-Spannung V_{GS_HS} des MOSFET HS, ein Gatestrom I_{g_LS} des MOSFET LS, ein Gatestrom I_{g_HS} des MOSFET HS und die Phasenspannung V_{PHASE} dargestellt sind. Figur 6 zeigt ein schematisches Diagramm einer Schaltsequenz der Halbbrücke HB1 bei freilaufendem MOSFET HS, wobei eine Gate-Source-Spannung V_{GS_LS} des MOSFET LS, eine Gate-Source-Spannung V_{GS_HS} des MOSFET HS, ein Gatestrom I_{g_LS} des MOSFET LS, ein Gatestrom I_{g_HS} des MOSFET HS und die Phasenspannung V_{PHASE} dargestellt sind.

In einer Ausführungsform erfolgt die Ansteuerung der Gates G entsprechend der in WO 2014/173969 A1 beschriebenen Steuerungsvorrichtung und dem dafür beschriebenen Verfahren, insbesondere gemäß den Figuren 1 und 3 bis 18 und der Beschreibung auf Seiten 8 bis 26.

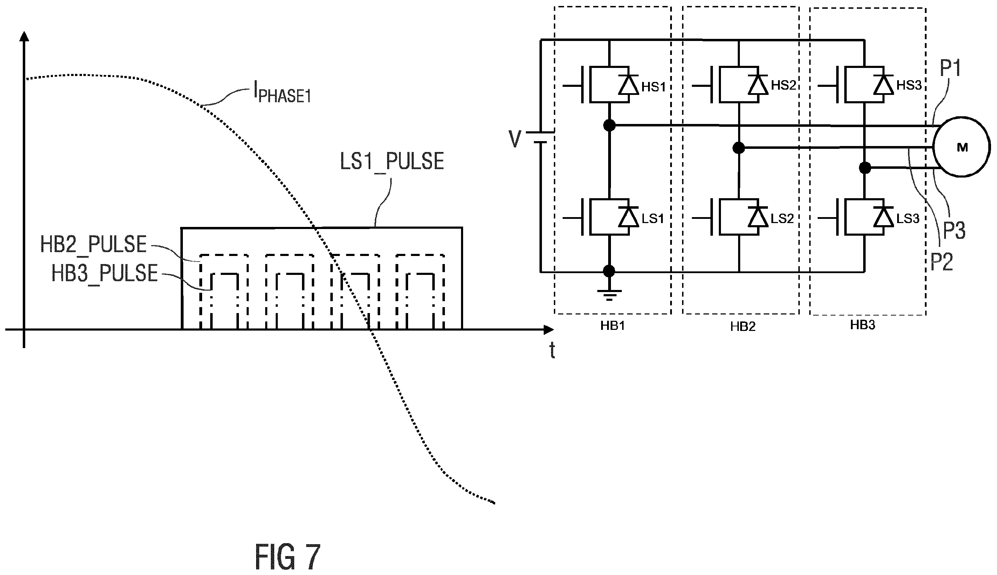

Das Ausschalten wird in der gleichen Weise durchgeführt wie das Einschalten: Wenn ein Gatestrom I_{g} mit mindestens drei verschiedenen Stromwerten Ig1, Ig2, Ig3 zum Einschalten verwendet wurde, dann wird er auch beim Ausschalten verwendet. Wenn ein konstanter Strom beim Einschalten verwendet wurde, dann wird er auch beim Ausschalten verwendet, außer wenn lange Impulse detektiert werden, die eine Änderung in der Polarität des Phasenstroms I_{PHASE} verursachen. Bei Anwendungen, in denen ein bürstenloser Gleichstrommotor verwendet wird, könnten lange Impulse entweder auf den MOSFET HS oder den MOSFET LS angewandt werden. Diese Impulse verursachen die Inversion der Polarität des Phasenstroms I_{PHASE} wie in Figur 7 gezeigt ist. Figur 7 zeigt ein schematisches Schaltbild einer Brückenschaltung 1 zum Betrieb eines dreiphasigen Elektromotors M, wobei drei Halbbrücken HB1, HB2, HB3 für je eine Phase P1, P2, P3 vorgesehen sind. Ferner ist ein schematisches Diagramm gezeigt, in dem der Phasenstrom I_{PHASE1} der ersten Halbbrücke HB1 sowie der Schaltzustand LS1_PULSE des MOSFET LS1 der ersten Halbbrücke HB1, der Schaltzustand HB2_PULSE der zweiten Halbbrücke HB2 und der Schaltzustand HB3_PULSE der dritten Halbbrücke HB3 über der Zeit t dargestellt sind. Die Schaltzustände HB2_PULSE und HB3_PULSE entsprechen den pulsweitenmodulierten Signalen zur Steuerung der Halbbrücken HB2, HB3. Beispielsweise kann der MOSFET LS1, LS2, LS3 im unteren Brückenzweig der jeweiligen Halbbrücke HB1, HB2, HB3 eingeschaltet werden, wenn das jeweilige pulsweitenmodulierte Signal einen Low-Pegel aufweist und der MOSFET HS1, HS2, HS3 im oberen Brückenzweig der jeweiligen Halbbrücke HB1, HB2, HB3 kann eingeschaltet werden, wenn das jeweilige pulsweitenmodulierte Signal einen High-Pegel aufweist. Die pulsweitenmodulierten Signale sind lediglich zur besseren Erkennbarkeit mit unterschiedlichen Amplituden dargestellt. Der Schaltzustand LS1_PULSE entspricht einem invertierten Schaltzustand HB1_PULSE (nicht dargestellt). Bezüglich Figur 7 soll beispielhaft angenommen werden, dass der MOSFET LS1 in der Halbbrücke HB1 angeschaltet wird, wenn der entsprechende Phasenstrom I_{PHASE1} positiv ist. Dann ist der MOSFET LS1 beim Einschalten freilaufend. Es soll weiter angenommen werden, dass der MOSFET LS1 lange genug eingeschaltet bleibt, dass ein Polaritätswechsel auf dem Phasenstrom I_{PHASE1} der Phase P1 stattfindet. Beim Ausschalten ist der MOSFET LS1 daher nicht freilaufend. Wenn der MOSFET LS1 mit konstantem Gatestrom I_{g} ausgeschaltet wird, so kann er ein schnelles Schalten generieren, wodurch Probleme bezüglich der elektromagnetischen Verträglichkeit verursacht werden können. Die Gatetreiberschaltung 2, in der die Erfindung implementiert ist, ist imstande, lange Impulse beider MOSFETs HS und LS jeder Halbbrücke HB1, HB2, HB3 zu detektieren, indem die Impulse auf den anderen Halbbrücken HB1, HB2, HB3 gezählt werden. Für den in Figur 7 betrachteten Fall wird daher, wenn der MOSFET LS1 eingeschaltet wird, ein Zähler gestartet. Der Zählerstand wird jedes Mal, wenn ein neuer Arbeitszyklus der Pulsweitenmodulation auf irgendeine der anderen Halbbrücken HB2, HB3 angewandt wird, um eins erhöht. Wenn der Zähler einen bestimmten Wert erreicht hat, dann wird das Abschalten des MOSFETs LS1 unter Verwendung mindestens dreier unterschiedlicher Stromwerte Ig1, Ig2, Ig3 durchgeführt.

Das Ziel beim Ansteuern eines MOSFET mit mindestens drei verschiedenen Stromwerten Ig1, Ig2, Ig3 beim Schalten, wie es in WO2014/173969 A1 beschrieben und in Figur 8 gezeigt ist, besteht darin, bedarfsabhängig Emissionen zu verringern und Schaltverluste zu optimieren. Das in WO2014/173969 A1 beschriebene Verfahren verwendet eine Überschwingmessung, um die Zeitpunkte t1_{ON}, t1_{OFF}, t2_{ON}, t2_{OFF} beim Einschalten und Ausschalten in der Regelung anzupassen. Die Überschwingmessung erbringt im Wesentlichen folgende Information:
- Wann und wie schnell wird beim Einschalten das Millerplateau MP erreicht.
- Wann und wie schnell wird beim Ausschalten das Millerplateau MP verlassen.

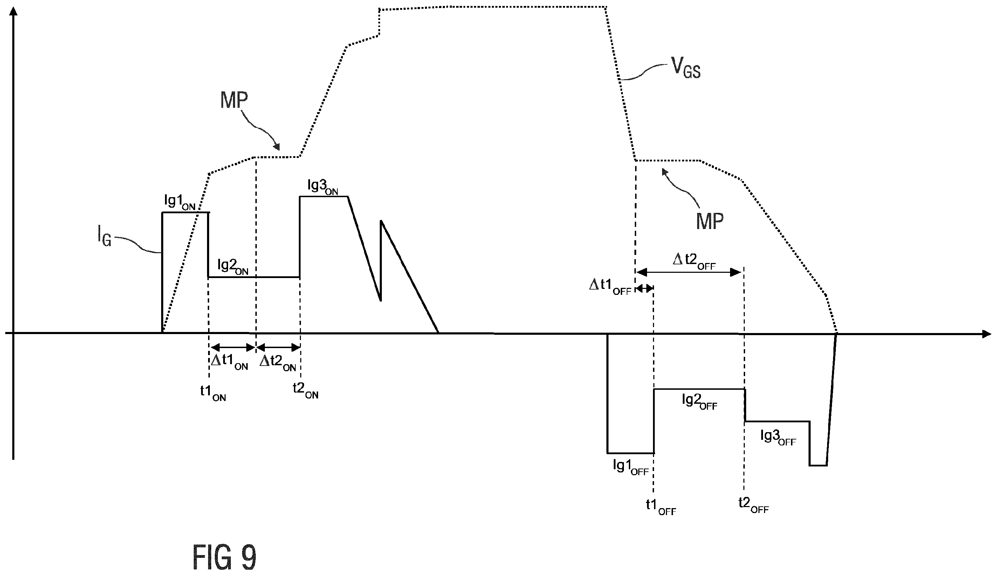

Die vorliegende Erfindung ist daher eine Weiterentwicklung der in WO2014/173969 A1 beschriebenen Vorgehensweise. Die Überschwingmessung kann durch jede andere Methode zur Detektion des Millerplateaus MP ersetzt werden. Sobald die Information über das Millerplateau MP bekannt ist können die Zeitpunkte t1_{ON}, t2_{ON} für das Einschalten und die Zeitpunkte t1_{OFF} und t2_{OFF} für das Ausschalten berechnet und ausgehend davon angepasst werden wie in Figur 9 gezeigt. Figur 9 zeigt ein schematisches Diagramm mit einer Schaltsequenz eines MOSFET HS, LS. Beispielsweise findet beim Einschalten der Wechsel vom Stromwert Ig1_{ON} zum Stromwert Ig2_{ON} um eine Zeitdifferenz Δt1_{ON} vor dem Beginn des Millerplateaus MP statt. Der Wechsel vom Stromwert Ig2_{ON} zum Stromwert Ig3_{ON} findet beim Einschalten um eine Zeitdifferenz Δt2_{ON} nach dem Beginn des Millerplateaus MP statt. Beim Ausschalten findet der Wechsel vom Stromwert Ig1_{OFF} zum Stromwert Ig2_{OFF} um eine Zeitdifferenz Δt1_{OFF} nach dem Erreichen des Millerplateaus MP statt. Der Wechsel vom Stromwert Ig2_{OFF} zum Stromwert Ig3_{OFF} findet beim Ausschalten um eine Zeitdifferenz Δt2_{OFF} verschoben statt.

Die Zeitdifferenzen Δt1_{ON}, Δt2_{ON}, Δt1_{OFF} und Δt2_{OFF} können in Abhängigkeit von den Erfordernissen der Anwendung positiv oder negativ sein.

Es werden zwei Typen von Millerplateau-Detektoren 2.2 vorgeschlagen, die für die vorliegende Erfindung besonders geeignet sind:
1) Einen Millerplateau-Detektor 2.2, der anzeigt, wann das Millerplateau MP beginnt.
2) Einen Millerplateau-Detektor 2.2, der anzeigt, wann das Millerplateau MP beginnt und endet.

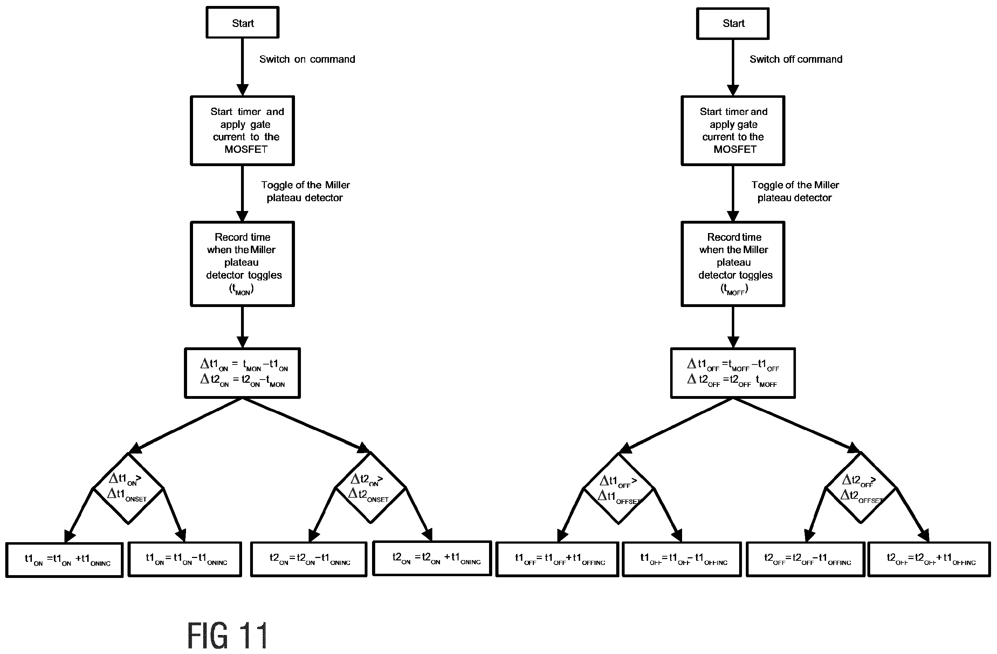

Bei einem Millerplateau-Detektor 2.2 gemäß der ersten Ausführungsform wird das Millerplateau MP in jedem Arbeitszyklus der Pulsweitenmodulation, in der der MOSFET LS, HS nicht freilaufend ist, detektiert, und diese Information wird verwendet, um die Zeitpunkte t1_{ON} t2_{ON} für das Einschalten und die Zeitpunkte t1_{OFF} und t2_{OFF} für das Ausschalten anzupassen, um die Zeitdifferenzen Δt1_{ON}, Δt2_{ON}, Δt1_{OFF} und Δt2_{OFF} im nächsten Arbeitszyklus näher an einem Zielwert der Zeitdifferenz Δt1_{ONSET}, Δt2_{ONSET}, Δt1_{OFFSET}, Δt2_{OFFSET} zu erhalten, wie in Figur 11 gezeigt ist. Figur 11 ist eine schematische Ansicht einer Zustandsmaschine des MOSFETS HS oder LS für die Anpassung der Zeitpunkte t1_{ON}, t2_{ON} für das Einschalten und die Zeitpunkte t1_{OFF} und t2_{OFF} für das Ausschalten, wenn der jeweilige MOSFET HS, LS mit mindestens drei Stromwerten Ig1, Ig2, Ig3 betrieben wird. Figur 11 stellt eine mögliche Ausführungsform des Reglers 2.1 dar. Bei einem Einschaltkommando für den MOSFET HS, LS wird ein Zeitgeber gestartet und der MOSFET HS, LS mit dem Gatestrom I_{g} angesteuert. Sobald der Millerplateau-Detektor 2.2 ein Millerplateau MP detektiert, wird der entsprechende Zeitpunkt t_{MON} gespeichert. Anschließend wird die Zeitdifferenz Δt1_{ON} als Differenz der Zeitpunkte t_{MON} und t1_{ON} bestimmt und es wird die Zeitdifferenz Δt2_{ON} als Differenz der Zeitpunkte t2_{ON} und t_{MON} bestimmt.

Im Arbeitszyklus werden, falls die Differenz zwischen dem Zielwert Δt1_{ONSET}, Δt2_{ONSET}, Δt1 _{OFFSET}, Δt2_{OFFSET} und dem jeweiligen gemessenen Wert Δt1_{ON}, Δt2_{ON}, Δt1_{OFF}, Δt2_{OFF} nicht 0 ist, die relevanten Zeitpunkte t1_{ON}, t2_{ON}, t1_{OFF} und t2_{OFF} um ein Inkrement t1_{ONINC}, t2_{ONINC}, t1_{OFFINC} und t2_{OFFINC} erhöht/verkleinert, welches konstant oder proportional zum Fehlersignal (Differenz zwischen dem Zielwert Δt und dem gemessenen Wert Δt) sein kann.

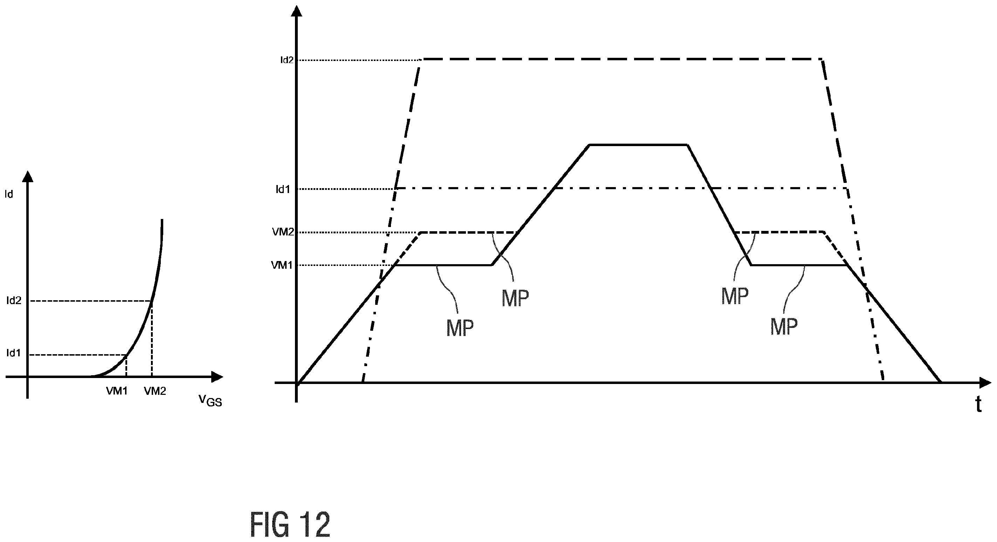

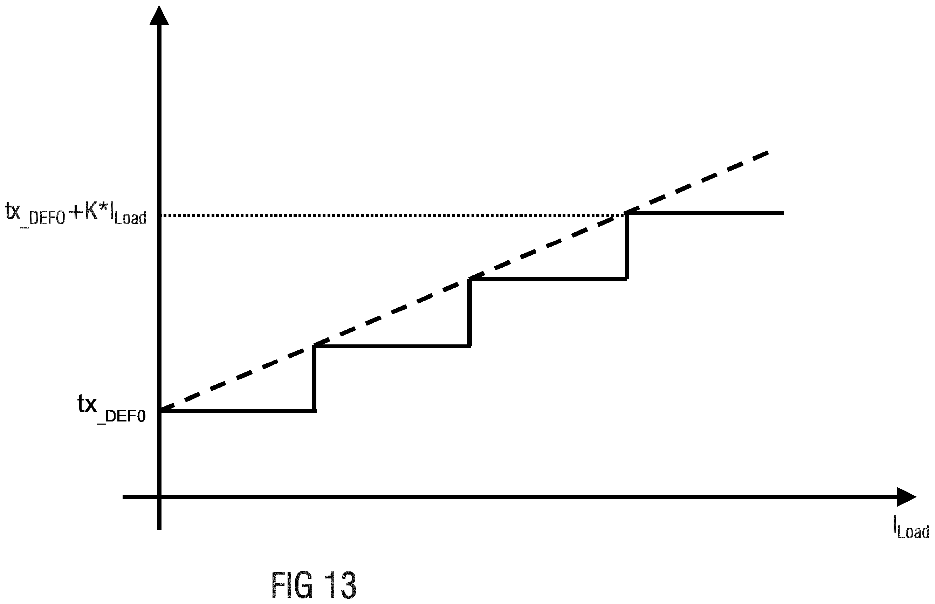

Die Regelung der Zeitpunkte t1_{ON}, t2_{ON}, t1_{OFF} und t2_{OFF} basiert auf der Detektion des Millerplateaus MP. Der Laststrom I_{LOAD} ist normalerweise der Parameter mit der schnellsten Dynamik, der das Millerplateau MP beeinflussen kann. Wenn der Laststrom I_{LOAD} beziehungsweise der Drainstrom Id von einem Stromwert Id1 auf einen Stromwert Id2 erhöht wird, erhöht sich auch die Spannung VM1, VM2 des Millerplateaus MP wie in Figur 12 gezeigt ist (sowohl die Übertragungseigenschaften als auch die Kurven im Zeitbereich). Die Zeitpunkte t1_{ON}, t2_{ON}, t1_{OFF} und t2_{OFF} sollen entsprechend der Spannung VM1, VM2 des Millerplateaus MP angepasst werden, um die gewünschten Zeitdifferenzen Δt1_{ON}, Δt2_{ON}, Δt1_{OFF} and Δt2_{OFF} beizubehalten. Wenn beispielsweise die Spannung VM1, VM2 des Millerplateaus MP sich erhöht, dann soll der Zeitpunkt t1_{ON} auch erhöht werden, um die gewünschte Zeitdifferenz Δt1_{ON} zu erhalten. Für jeden Zeitpunkt t1_{ON}, t2_{ON}, t1_{OFF} und t2_{OFF} ist ein Default-Wert tₓ__{DEF} definiert. Der Default-Wert tₓ__{DEF} wird zu Beginn verwendet, um den Regler 2.1 zu initialisieren. Um den Regler 2.1 zu beschleunigen kann ein Verhältnis (linear oder nicht-linear gemäß Erfordernis) zum Laststrom I_{LOAD} wie in Figur 13 gezeigt implementiert werden (Es werden nur lineare Fälle gezeigt.). Für jeden Laststrom I_{LOAD} (oder Laststrombereich, wenn die Implementierung auf digitale Weise erfolgt) kann der relevante Default-Wert tₓ__{DEF} mittels eines konstanten Faktors K berechnet werden (beispielsweise tₓ__{DEF} = t_{x_DEF0} + K*I_{Load}). Für jeden Laststrom I_{LOAD} (Laststrombereich) kann der Regler 2.1 dann die Regelung durchführen und den optimalen Wert finden. Der konstante Faktor K kann für die jeweilige Anwendung festgelegt sein.

Ein Regler 2.1 gemäß der zweiten Ausführungsform baut auf der ersten Ausführungsform auf. Bei der Verwendung von mindestens drei Stromwerten Ig1, Ig2, Ig3 für den Gatestrom I_{g} wird der Gatestrom I_{g} im zweiten Abschnitt während der Kommutierung (Umschaltung) auf den zweiten Stromwert Ig2 heruntergesetzt, damit das Überschwingen in einem akzeptablen Bereich bleibt. Die Detektion des Millerplateaus MP zusammen mit dem Beibehalten der Zielwerte der Zeitdifferenz Δt1_{ONSET}, Δt2_{ONSET}, Δt1_{OFFSET} und Δt2_{OFFSET} stellt sicher, dass das Gate G des MOSFET HS, LS während der Kommutierung (Umschaltung) mit dem gewählten zweiten Stromwert Ig2 des Gatestroms I_{g} angesteuert wird. Ein fester Stromwert Ig2 des Gatestroms I_{g} ist jedoch nicht optimal für den gesamten Bereich von Lastströmen I_{LOAD}.

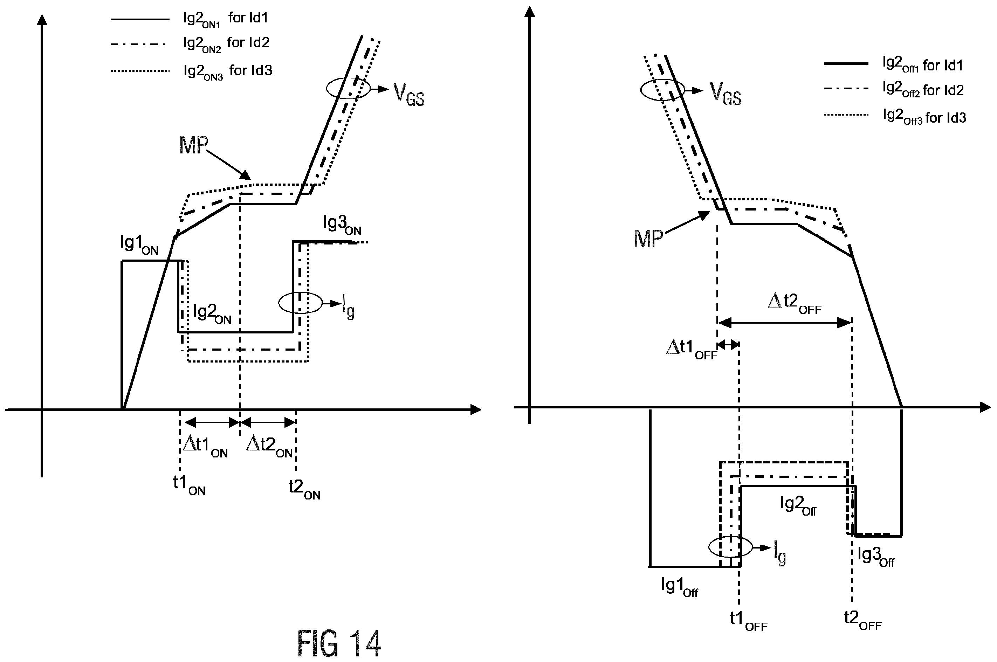

Daher kann bei der Verwendung von mindestens drei Stromwerten Ig1, Ig2, Ig3 für den Gatestrom I_{g} der zweite Stromwert Ig2 während des Einschaltens und Ausschaltens des MOSFET HS, LS entsprechend dem Pegel des Laststroms I_{LOAD} angepasst werden (siehe Figur 14). Figur 14 zeigt links ein schematisches Diagramm einer Einschaltsequenz und rechts ein schematisches Diagramm einer Ausschaltsequenz eines MOSFET HS, LS.

Diese Anpassung des Stromwerts Ig2 bietet die zusätzliche Möglichkeit, das Überschwingen und die Leistungsverluste zu optimieren, indem die Steilheit des Anstiegs der Gate-Source-Spannung V_{GS} während der Kommutierung (Umschaltung) des Stroms verändert wird wie in Figur 14 gezeigt ist.

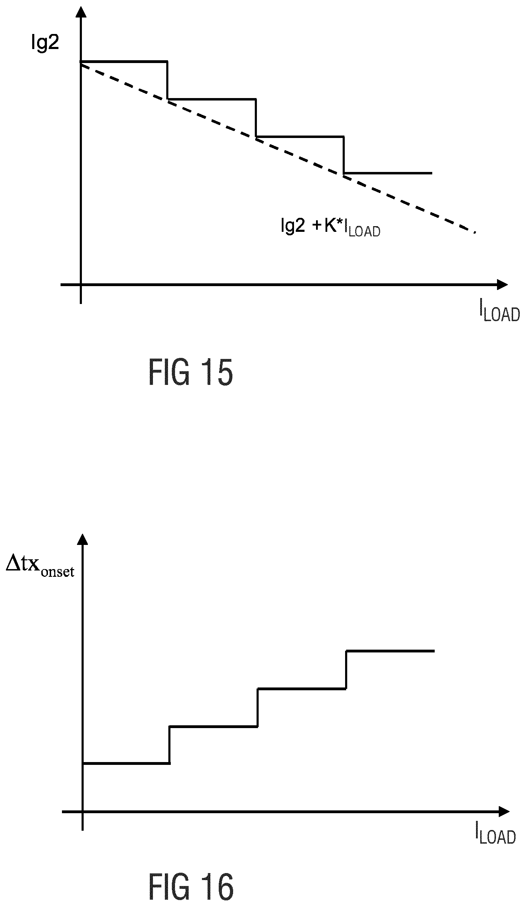

Hierzu wird der Bereich der Lastströme I_{LOAD} in N Unterbereiche unterteilt wie in Figur 15 gezeigt. Figur 15 ist ein schematisches Diagramm des zweiten Stromwertes Ig2 des Gatestroms I_{g} in Abhängigkeit vom Laststrom I_{LOAD}. Jeder Unterbereich entspricht einem bestimmten Stromwert Ig2. Die Steilheit dieser Kurve wird entsprechend den Erfordernissen der elektromagnetischen Verträglichkeit und den Verlusterfordernissen festgelegt. Für jeden Unterbereich des Laststroms I_{LOAD} wird der Stromwert Ig2 angepasst, um die Zielwerte der Zeitdifferenz Δt1_{ONSET}, Δt2_{ONSET}, Δt1_{OFFSET} und Δt2_{OFFSET} zu regeln.

Die Regelung der vorgegebenen Werte der Zeitdifferenz Δtx erfolgt analog dem in Figur 11 gezeigten Flowchart. Wenn beispielsweise Δt1_{ON} größer ist als Δt1_{ONSET}, dann wird Ig2_{ON} um ein Inkrement Ig2_{ONINC} erhöht. Umgekehrt wird, wenn Δt1_{ON} kleiner ist als Δt1_{ONSET}, Ig2_{ON} um das Inkrement Ig2_{ONINC} verringert. Die Zielwerte der Zeitdifferenz Δt1_{ONSET}, Δt2_{ONSET}, Δt1_{OFFSET} und Δt2_{OFFSET} sind Funktionen der Unterteilung des Laststroms I_{LOAD}. Die Zielwerte der Zeitdifferenz Δtx_{ONSET} und Δtx_{OFFSET} hängen mit dem Laststrom I_{LOAD} zusammen wie in Figur 16 gezeigt ist. Dies ermöglicht eine einfache Implementierung in der Gatetreiberschaltung 2. Figur 16 ist ein schematisches Diagramm des gewünschten Wertes Δtx_{ONSET} in Abhängigkeit vom Laststrom I_{LOAD}.

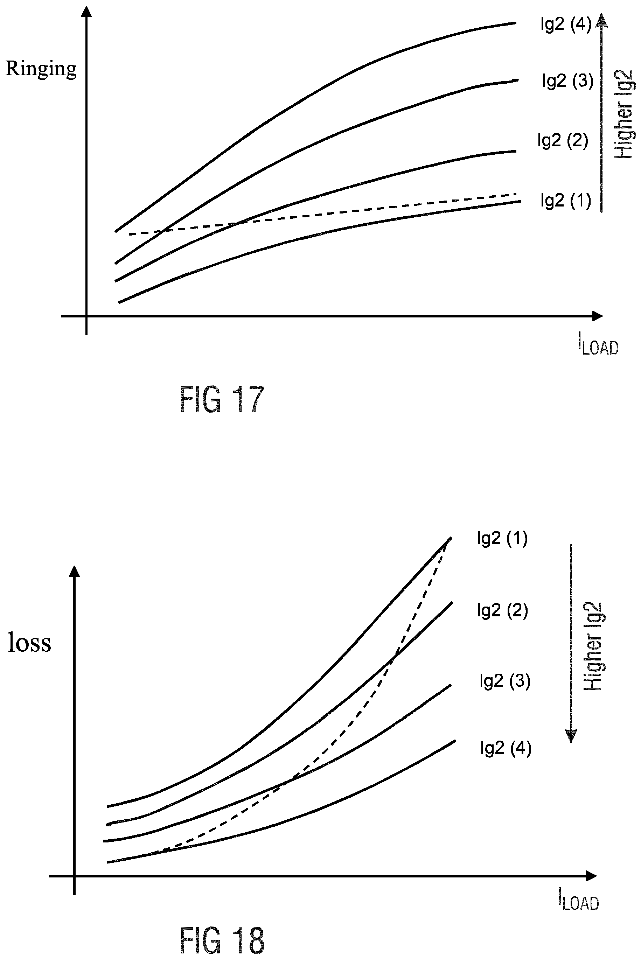

Figur 17 ist ein schematisches Diagramm zur Darstellung des Überschwingverhaltens für verschiedene zweite Stromwerte Ig2(1) bis Ig2(4) des Gatestroms I_{g}. Figur 18 ist ein schematisches Diagramm zur Darstellung des Verlustverhaltens für verschiedene zweite Stromwerte Ig2(1) bis Ig2(4) des Gatestroms I_{g}. Da das Verfahren Δtx_{SET}-Werte für verschiedene Laststrombereiche vorsieht, wählt der Regelalgorithmus verschiedene Stromwerte Ig2 abhängig vom Unterbereich des Laststroms I_{LOAD}. Dies ermöglicht mehr Flexibilität, um die elektromagnetische Verträglichkeit und die Verluste beim Schalten zu optimieren. Wenn Ig2 beispielsweise von Ig2(4) bis Ig2(1) variiert, dann sind die Bereiche oberhalb der gestrichelten Linie Leistungsgewinne. In den Figuren 17 und 18 ist der zweite Stromwert Ig2(1) am geringsten und der zweite Stromwert Ig2(4) am höchsten. Wenn beispielsweise Ig2(4) als zweiter Stromwert gewählt wird, so erfolgt das Schalten des MOSFET von Aus nach An oder von An nach Aus schneller, da das Gate schneller aufgeladen wird. Daher fällt der Leistungsverlust während des Schaltens geringer aus, das Überschwingenniveau ist jedoch höher.

Die Default-Werte für t1ₒₙ, t2ₒₙ, t1_{off} und t1_{off} werden gemäß der ersten Ausführungsform für den ersten Unterbereich des Laststroms I_{LOAD} ermittelt. Die Default-Werte für t1ₒₙ, t2ₒₙ, t1_{off} und t1_{off} für die anderen Unterbereiche des Laststroms I_{LOAD} hängen untereinander linear oder über eine einfache nichtlineare Funktion zusammen wie in Figur 13 gezeigt ist. Jedes Mal, wenn der Phasenstrom in dem ersten Unterbereich des Laststroms liegt, wird das Verfahren gemäß der ersten Ausführungsform ausgeführt, um zu den gewünschten Default-Werten tₓ__{DEF} zu gelangen.

Auch dann, wenn die Default-Werte für t1_{on_def} nicht innerhalb des einen Zyklus der elektrischen Kommutierung konvergiert werden, beeinträchtigt dies die Leistung nicht drastisch. Dies liegt daran, dass das Überschwingen über einen Bereich von t1ₒₙ-Werten konstant ist. Der letzte Wert für t1ₒₙ am Ende der Iteration (in einem Unterbereich des Laststroms I_{LOAD}) kann verwendet werden, um die initialen Werte für t1ₒₙ für die nächsten Unterbereiche zu bilden. Dies trifft auch auf die verbleibenden Default-Werte zu.

Um einen minimalen Durchgangswiderstand R_{DS(on)} am MOSFET HS, LS zu erzielen, soll die Gate-Source-Spannung V_{GS} einen hinreichend hohen Wert erreichen (beispielsweise V_{GS}>10V). Dies kann bei Verwendung von Stromquellen mit einer Spannung, die sehr nah an der angestrebten Gate-Source-Spannung V_{GS} liegt, unmöglich sein. Wenn das Einschalten abgeschlossen ist, ist es aus diesem Grund erforderlich, den Stromquellen-Modus zu verlassen, um die finale Gate-Source-Spannung V_{GS} zu erreichen. Dies erfolgt am Ende des Zeitraums, in dem der dritte Stromwert Ig3 zum Ansteuern des MOSFET HS, LS verwendet wird (Figur 8). Der Zeitpunkt am Ende dieses Zeitraums kann auf verschiedene Weise bestimmt werden, beispielsweise mittels eines Zeitgebers, der am Beginn des Millerplateaus MP ausgelöst wird oder mittels eines Komparators für die Gate-Source-Spannung V_{GS}. Da beim freilaufenden MOSFET HS, LS kein Millerplateau MP vorhanden ist kann das Ende des Stromquellen-Modus durch einen Komparator für die Gate-Source-Spannung V_{GS} oder einen Zeitgeber bestimmt werden, der startet, wenn das Schalten beginnt.

Etwas Ähnliches geschieht auch beim Ausschalten: Während der Aus-Zeit soll unerwünschtes Anschalten des MOSFET HS, LS infolge von Kopplung mit anderen Signalen vermieden werden. In diesem Falle könnte auch die Stromquelle wegen niedriger Versorgungsspannung der Stromquelle selbst nicht den angestrebten Pegel erreichen. Daher muss der Stromquellen-Modus auch in diesem Falle verlassen werden. Dies geschieht, wenn der Zeitraum, in dem der dritte Stromwert Ig3 zum Ansteuern des MOSFET HS, LS verwendet wird, vorüber ist. Das Ende dieses Zeitraums kann mittels derselben Komparatoren für VGS bestimmt werden, die bereits verwendet werden, um zu prüfen wann beide MOSFETs HS, LS ausgeschaltet sind.

Die Gatetreiberschaltung 2 kann vollständig oder teilweise in einem integrierten Schaltkreis, beispielsweises einem ASIC oder ASSP, implementiert sein.

## Patentansprüche

1. Verfahren zum Schalten von Leistungstransistoren (HS, LS) in einer Leistungstransistorschaltung (1), wobei die Leistungstransistoren (HS, LS) jeweils ein Gate (G) aufweisen, das bei einer Einschaltsequenz und/oder einer Ausschaltsequenz sequentiell mit mindestens drei Steuerwerten (Ig1, Ig2, Ig3) angesteuert wird, zwischen denen zu bestimmten Zeitpunkten (t1, t2) umgeschaltet wird, wobei
die Zeitpunkte (t1, t2) mittels eines Reglers (2.1) bestimmt oder modifiziert werden, der von einem Millerplateau-Detektor (2.2) zur Detektion eines Millerplateaus (MP) in einer Gate-Source-Spannung (V_{GS}) des jeweiligen Leistungstransistors (HS, LS) angesteuert wird,
wobei beim Einschalten der Wechsel von einem ersten Steuerwert (Ig1_{ON}) zu einem zweiten Steuerwert (Ig2_{ON}) um eine Zeitdifferenz (Δt1_{ON}) vor dem Beginn des Millerplateaus (MP) stattfindet und/oder der Wechsel vom zweiten Steuerwert (Ig2_{ON}) zu einem dritten Steuerwert (Ig3_{ON}) beim Einschalten um eine Zeitdifferenz (Δt2_{ON}) nach dem Beginn des Millerplateaus (MP) stattfindet und/oder beim Ausschalten der Wechsel vom ersten Steuerwert (Ig1_{OFF}) zum zweiten Steuerwert (Ig2_{OFF}) um eine Zeitdifferenz (Δt1_{OFF}) nach dem Erreichen des Millerplateaus (MP) stattfindet und/oder beim Ausschalten der Wechsel vom zweiten Steuerwert (Ig2_{OFF}) zum dritten Steuerwert (Ig3_{OFF}) um eine Zeitdifferenz (Δt2_{OFF}) nach dem Erreichen des Millerplateaus (MP) stattfindet, wobei der zweite Steuerwert (Ig2) während des Einschaltens und Ausschaltens des Leistungstransistors (HS, LS) in Abhängigkeit von einem Pegel eines Laststroms (I_{LOAD}) angepasst wird.

2. Verfahren nach Anspruch 1,
**dadurch gekennzeichnet, dass** dem Millerplateau-Detektor (2.2) eine Phasenspannung (V_{PHASE}) einer Halbbrücke (HB1 bis HB3) als Teil der Leistungstransistorschaltung (1) oder irgendeine Spannung oder irgendein Strom dieser Halbbrücke (HB1 bis HB3) zur Detektion des Millerplateaus (MP) zugeführt wird oder wobei der Millerplateau-Detektor (2.2) auf der Detektion von Spannungstransienten an einem Source-Anschluss eines Leistungstransistor (LS) im unteren Brückenzweig dieser Halbbrücke (HB1 bis HB3) oder auf der Detektion von Überschwingen basiert.

3. Verfahren nach Anspruch 1 oder 2,
**dadurch gekennzeichnet, dass** mittels des Millerplateau-Detektors (2.2) detektiert wird, wann das Millerplateau (MP) beginnt oder wann das Miller-plateau (MP) beginnt und endet.

4. Verfahren nach einem der vorhergehenden Ansprüche,
**dadurch gekennzeichnet, dass** das Millerplateau (MP) in jedem Arbeitszyklus detektiert wird, in dem der jeweilige Leistungstransistor (LS, HS) nicht freilaufend ist, wobei diese Information verwendet wird, um die Zeitpunkte (t1, t2) für den nächsten Arbeitszyklus anzupassen, in dem der jeweilige Leistungstransistor (LS, HS) nicht freilaufend ist.

5. Verfahren nach einem der Ansprüche 2 bis 4,
**dadurch gekennzeichnet, dass** das Millerplateau (MP) mittels eines im Millerplateau-Detektor (2.2) enthaltenen Komparators anhand der Phasenspannung (V_{PHASE}) detektiert wird.

6. Verfahren nach einem der vorhergehenden Ansprüche,
**dadurch gekennzeichnet, dass** die Ansteuerung mit mindestens drei Steuerwerten (Ig1, Ig2, Ig3) nur für nicht freilaufende Leistungstransistoren (HS, LS) in der Leistungstransistorschaltung (1) erfolgt, während freilaufende Leistungstransistoren (HS, LS) mit einem konstanten Steuerwert (Ig) angesteuert werden.

7. Verfahren nach einem der Ansprüche 2 bis 6,
**dadurch gekennzeichnet, dass** zur Detektion, ob ein Leistungstransistor (HS, LS) in einer Halbbrücke (HB1 bis HB3) im nächsten Arbeitszyklus freilaufend ist, während einer Totzeit (t_{d}), während der beide Leistungstransistoren (HS, LS) derselben Halbbrücke (HB1 bis HB3) ausgeschaltet sind, die Phasenspannung (V_{PHASE}) gemessen wird, wobei dann, wenn die Phasenspannung (V_{PHASE}) hoch ist, der Leistungstransistor (LS) in einem unteren Zweig derselben Halbbrücke (HB1 bis HB3) als im nächsten Arbeitszyklus freilaufend erkannt wird.

8. Verfahren nach einem der Ansprüche 2 bis 7,
**dadurch gekennzeichnet, dass** in einer Leistungstransistorschaltung (1) mit mindestens zwei Halbbrücken (HB1 bis HB3) ein Leistungstransistor (HS, LS), der zum Einschalten mit mindestens drei verschiedenen Steuerwerten (Ig1, Ig2, Ig3) angesteuert wurde, grundsätzlich auch zum Ausschalten im gleichen Arbeitszyklus mit mindestens drei verschiedenen Steuerwerten (Ig1, Ig2, Ig3) angesteuert wird, und dass ein Leistungstransistor (HS, LS), der zum Einschalten mit einem konstanten Steuerwert (Ig) angesteuert wurde, grundsätzlich auch zum Ausschalten im gleichen Arbeitszyklus mit konstantem Steuerwert (Ig) angesteuert wird, außer wenn ein langer Impuls detektiert wird, der eine Änderung in der Polarität des Phasenstroms (I_{PHASE}) der jeweiligen Halbbrücke (HB1 bis HB3) verursacht.

9. Verfahren nach Anspruch 8,
**dadurch gekennzeichnet, dass** zum Ermitteln eines langen Impulses beim Einschalten eines Leistungstransistors (HS, LS) in einer der Halbbrücken (HB1 bis HB3) ein Zähler gestartet wird, dessen Zählerstand jedes Mal, wenn ein neuer Arbeitszyklus auf eine der anderen Halbbrücken (HB1, HB2, HB3) angewandt wird, um eins erhöht wird, wobei dann, wenn der Zähler einen bestimmten Wert erreicht hat, das Abschalten des Leistungstransistors (HS, LS) unter Verwendung mindestens dreier unterschiedlicher Steuerwerte (Ig1, Ig2, Ig3) durchgeführt wird.

10. Verfahren nach einem der vorhergehenden Ansprüche,
**dadurch gekennzeichnet, dass** die Zeitpunkte (t1, t2) in Abhängigkeit vom Laststrom (I_{LOAD}) variiert werden und/oder dass mindestens ein Zielwert mindestens einer der Zeitdifferenzen (Δtx_{ONSET}, tx_{OFFSET}) in Abhängigkeit vom Laststrom (I_{LOAD}) variiert wird.

11. Verfahren nach einem der vorhergehenden Ansprüche,
**dadurch gekennzeichnet, dass** bei der Verwendung von mindestens drei Steuerwertenwerten (Ig1, Ig2, Ig3) der zweite Steuerwert (Ig2) während des Einschaltens und Ausschaltens des Leistungstransistors (HS, LS) entsprechend dem Pegel des Laststroms (I_{LOAD}) angepasst wird.

12. Verfahren nach einem der vorhergehenden Ansprüche,
**dadurch gekennzeichnet, dass** die Steuerwerte (Ig1, Ig2, Ig3) mittels einer vom Regler (2.1) angesteuerten Quelle (2.4) eingestellt werden, die in einem Stromquellenmodus betrieben wird, wobei die Quelle (2.4) am Ende der Einschaltsequenz und/oder der Ausschaltsequenz vom Stromquellenmodus in einen Spannungsquellenmodus umgeschaltet wird.

13. Verfahren nach Anspruch 12,
**dadurch gekennzeichnet, dass** das Ende der Einschaltsequenz und/oder der Ausschaltsequenz mittels
- eines Zeitgebers, der am Beginn des Millerplateaus (MP) ausgelöst wird, oder
- eines Komparators für die Gate-Source-Spannung (V_{GS}) detektiert wird.

## Claims

1. Method for switching power transistors (HS, LS) in a power transistor circuit (1), wherein the power transistors (HS, LS) each have a gate (G), which is driven sequentially by at least three control values (Igl, Ig2, Ig3) in the case of a switch-on sequence and/or a switch-off sequence, there being a switchover between said control values at specific times (t1, t2), wherein
the times (t1, t2) are determined or modified by means of a controller (2.1), which is driven by a Miller plateau detector (2.2) for detecting a Miller plateau (MP) in a gate-source voltage (V_{GS}) of the respective power transistor (HS, LS),
wherein, during switch-on, the change from a first control value (Ig1_{ON}) to a second control value (Ig2_{ON}) takes place by a time difference (Δt1_{ON}) prior to the beginning of the Miller plateau (MP) and/or the change from the second control value (Ig2_{ON}) to a third control value (Ig3_{ON}) takes place during switch-on by a time difference (At2_{ON}) after the beginning of the Miller plateau (MP) and/or, during switch-off, the change from the first control value (Ig1_{OFF}) to the second control value (Ig2_{OFF}) takes place by a time difference (Δt1_{OFF}) after the Miller plateau (MP) has been reached and/or, during switch-off, the change from the second control value (Ig2_{OFF}) to the third control value (Ig3_{OFF}) takes place by a time difference (Δt2_{OFF}) after the Miller plateau (MP) has been reached, wherein the second control value (Ig2) is adapted during the switch-on and switch-off of the power transistor (HS, LS) depending on a level of a load current (I_{LOAD}).

2. Method according to Claim 1,
**characterized in that** a phase voltage (V_{PHASE}) of a half-bridge (HB1 to HB3) as part of the power transistor circuit (1) or any voltage or any current of this half-bridge (HB1 to HB3) is supplied to the Miller plateau detector (2.2) for detecting the Miller plateau (MP), or wherein the Miller plateau detector (2.2) is based on the detection of voltage transients at a source connection of a power transistor (LS) in the lower bridge branch of this half-bridge (HB1 to HB3) or on the detection of overshoot.

3. Method according to Claim 1 or 2,
**characterized in that** the Miller plateau detector (2.2) is used to detect when the Miller plateau (MP) begins or when the Miller plateau (MP) begins and ends.

4. Method according to one of the preceding claims, **characterized in that** the Miller plateau (MP) is detected in each working cycle in which the respective power transistor (LS, HS) is not freewheeling, wherein this information is used to adapt the times (t1, t2) for the next working cycle in which the respective power transistor (LS, HS) is not freewheeling.

5. Method according to one of Claims 2 to 4, **characterized in that** the Miller plateau (MP) is detected by means of a comparator contained in the Miller plateau detector (2.2) on the basis of the phase voltage (V_{PHASE}).

6. Method according to one of the preceding claims, **characterized in that** the driving using at least three control values (Igl, Ig2, Ig3) only takes place for non-freewheeling power transistors (HS, LS) in the power transistor circuit (1), while freewheeling power transistors (HS, LS) are driven by a constant control value (Ig).

7. Method according to one of Claims 2 to 6, **characterized in that**, in order to detect whether a power transistor (HS, LS) in a half-bridge (HB1 to HB3) is freewheeling in the next working cycle, during a dead time (t_{d}) during which both power transistors (HS, LS) of the same half-bridge (HB1 to HB3) are switched off, the phase voltage (V_{PHASE}) is measured, wherein when the phase voltage (V_{PHASE}) is high, the power transistor (LS) in a lower branch of the same half-bridge (HB1 to HB3) is identified as freewheeling in the next working cycle.

8. Method according to one of Claims 2 to 7, **characterized in that**, in a power transistor circuit (1) having at least two half-bridges (HB1 to HB3), a power transistor (HS, LS) that has been driven to switch on by at least three different control values (Igl, Ig2, Ig3) is in principle also driven to switch off in the same working cycle by at least three different control values (Igl, Ig2, Ig3), and **in that** a power transistor (HS, LS) that has been driven to switch on by a constant control value (Ig) is in principle also driven to switch off in the same working cycle by a constant control value (Ig) apart from when a long pulse is detected, which causes a change in the polarity of the phase current (I_{PHASE}) of the respective half-bridge (HB1 to HB3).

9. Method according to Claim 8,
**characterized in that**, in order to determine a long pulse during switch-on of a power transistor (HS, LS) in one of the half-bridges (HB1 to HB3), a counter is started whose counter reading is increased by one every time a new working cycle is used on one of the other half-bridges (HB1, HB2, HB3), wherein when the counter has reached a specific value, the disconnection of the power transistor (HS, LS) is performed using at least three different control values (Igl, Ig2, Ig3).

10. Method according to one of the preceding claims, **characterized in that** the times (t1, t2) are varied depending on the load current (I_{LOAD}), and/or **in that** at least one target value of at least one of the time differences (Δtx_{ONSET}, tx_{OFFSET}) is varied depending on the load current (I_{LOAD}).

11. Method according to one of the preceding claims, **characterized in that**, when using at least three control values (Igl, Ig2, Ig3), the second control value (Ig2) is adapted corresponding to the level of the load current (I_{LOAD}) during the switch-on and switch-off of the power transistor (HS, LS).

12. Method according to one of the preceding claims, **characterized in that** the control values (Igl, Ig2, Ig3) are set by means of a source (2.4) that is driven by the controller (2.1) and is operated in a current source mode, wherein the source (2.4) is switched over from the current source mode to a voltage source mode at the end of the switch-on sequence and/or the switch-off sequence.

13. Method according to Claim 12,
**characterized in that** the end of the switch-on sequence and/or the switch-off sequence is detected by means of
- a timer that is triggered at the beginning of the Miller plateau (MP), or
- a comparator for the gate-source voltage (V_{GS}).

## Revendications

1. Procédé de commutation de transistors de puissance (HS, LS) dans un circuit à transistors de puissance (1), les transistors de puissance (HS, LS) comportant respectivement une grille (G) pilotée séquentiellement avec au moins trois valeurs de commande (Igl, Ig2, Ig3) selon une séquence de passage à l'état passant et/ou une séquence de passage à l'état non passant, entre lesquelles une commutation est effectuée à des instants déterminés (t1, t2),
les instants (t1, t2) étant déterminés ou modifiés au moyen d'un régulateur (2.1), lequel est piloté par un détecteur de plateau Miller (2.2) pour la détection d'un plateau Miller (MP) dans une tension grille-source (V_{GS}) du transistor de puissance (HS, LS) respectif,
le passage d'une première valeur de commande (Ig1_{ON}) à une deuxième valeur de commande (Ig2_{ON}) se produisant, lors du passage à l'état passant, avec un écart temporel (Δt1_{ON}) avant le début du plateau Miller (MP) et/ou le passage de la deuxième valeur de commande (Ig2_{ON}) à une troisième valeur de commande (Ig3_{ON}) se produisant, lors du passage à l'état passant, avec un écart temporel (Δt2_{ON}) après le début du plateau Miller (MP) et/ou le passage de la première valeur de commande (Ig1_{OFF}) à la deuxième valeur de commande (Ig2_{OFF}) se produisant, lors du passage à l'état non passant, avec un écart temporel (Δt1_{OFF}) après que le plateau Miller (MP) a été atteint et/ou le passage de la deuxième valeur de commande (Ig2_{OFF}) à la troisième valeur de commande (Ig3_{OFF}) se produisant, lors du passage à l'état non passant, avec un écart temporel (Δt2_{OFF}) après que le plateau Miller (MP) a été atteint, la deuxième valeur de commande (Ig2) étant ajustée pendant le passage à l'état passant et la de passage à l'état non passant du transistor de puissance (HS, LS) en fonction d'un niveau d'un courant de charge (I_{LOAD}).

2. Procédé selon la revendication 1,
**caractérisé en ce qu'**une tension de phase (V_{PHASE}) d'un demi-pont (HB1 à HB3) faisant partie du circuit à transistors de puissance (1) ou toute tension ou tout courant dudit demi-pont (HB1 à HB3) est fournie au détecteur de plateau Miller (2.2) pour la détection du plateau Miller (MP), ou **en ce que** le détecteur de plateau Miller (2.2) est basé sur la détection de transitoires de tension au niveau d'une borne de source d'un transistor de puissance (LS) dans la branche de pont inférieure dudit demi-pont (HB1 à HB3) ou sur la détection de suroscillations.

3. Procédé selon la revendication 1 ou 2,
**caractérisé en ce qu'**au moyen du détecteur de plateau Miller (2.2), il est détecté à quel moment le plateau Miller (MP) commence ou à quel moment le plateau Miller (MP) commence et se termine.

4. Procédé selon l'une des revendications précédentes, **caractérisé en ce que** le plateau Miller (MP) est détecté au cours de chaque cycle de travail lors duquel le transistor de puissance (LS, HS) respectif n'est pas en mode roue libre, ladite information étant utilisée pour ajuster les instants (t1, t2) du cycle de travail suivant lors duquel le transistor de puissance (LS, HS) respectif n'est pas en mode roue libre.

5. Procédé selon l'une des revendications 2 à 4, **caractérisé en ce que** le plateau Miller (MP) est détecté au moyen d'un comparateur compris dans le détecteur de plateau Miller (2.2) à partir de la tension de phase (V_{PHASE}) .

6. Procédé selon l'une des revendications précédentes, **caractérisé en ce que** la commande effectuée avec au moins trois valeurs de commande (Igl, Ig2, Ig3) n'est effectuée que pour des transistors de puissance (HS, LS) qui ne sont pas en mode roue libre dans le circuit à transistors de puissance (1), tandis que des transistors de puissance en mode roue libre (HS, LS) sont commandés avec une valeur de commande constante (Ig).

7. Procédé selon l'une des revendications 2 à 6, **caractérisé en ce que**, pour détecter si un transistor de puissance (HS, LS) d'un demi-pont (HB1 à HB3) est en mode roue libre lors du cycle de travail suivant, pendant un temps mort (t_{d}), au cours duquel les deux transistors de puissance (HS, LS) du même demi-pont (HB1 à HB3) sont non passants, la tension de phase (V_{PHASE}) est mesurée, et lorsque la tension de phase (V_{PHASE}) est élevée, le transistor de puissance (LS) d'une branche inférieure du même demi-pont (HB1 à HB3) est identifié comme étant en mode roue libre au cours du cycle de travail suivant.

8. Procédé selon l'une des revendications 2 à 7, **caractérisé en ce que**, dans un circuit à transistors de puissance (1) comportant au moins deux demi-ponts (HB1 à HB3), un transistor de puissance (HS, LS), commandé lors du passage à l'état passant avec au moins trois valeurs de commande différentes (Igl, Ig2, Ig3), est en principe également commandé lors du passage à l'état non passant dans le même cycle de travail avec au moins trois valeurs de commande différentes (Igl, Ig2, Ig3), et **en ce qu'**un transistor de puissance (HS, LS), qui a été commandé avec une valeur de commande constante (Ig) pour le passage à l'état passant, est également commandé pour le passage à l'état non passant dans le même cycle de travail avec une valeur de commande constante (Ig), sauf si une impulsion longue est détectée, laquelle provoque un changement de polarité du courant de phase (I_{PHASE}) du demi-pont (HB1 à HB3) respectif.

9. Procédé selon la revendication 8,
**caractérisé en ce que**, pour déterminer une impulsion longue lors du passage à l'état passant d'un transistor de puissance (HS, LS) de l'un des demi-ponts (HB1 à HB3), un compteur est démarré, la valeur du compteur étant incrémentée de un chaque fois qu'un nouveau cycle de travail est appliqué à l'un des autres demi-ponts (HB1, HB2, HB3), et lorsque le compteur a atteint une valeur déterminée, le transistor de puissance (HS, LS) est amené à l'état non passant en utilisant au moins trois valeurs de commande différentes (Igl, Ig2, Ig3).

10. Procédé selon l'une des revendications précédentes, **caractérisé en ce que** les instants (t1, t2) sont amenés à varier en fonction du courant de charge (I_{LOAD}) et/ou **en ce qu'**au moins une valeur cible d'au moins l'un des écarts temporels (Δt_{XONSET}, t_{XOFFSET}) est amenée à varier en fonction du courant de charge (I_{LOAD}).

11. Procédé selon l'une des revendications précédentes, **caractérisé en ce que**, lors de l'utilisation d'au moins trois valeurs de commande (Igl, Ig2, Ig3), la deuxième valeur de commande (Ig2) est ajustée en fonction du niveau du courant de charge (I_{LOAD}) lors du passage à l'état passant et du passage à l'état non passant du transistor de puissance (HS, LS).

12. Procédé selon l'une des revendications précédentes, **caractérisé en ce que** les valeurs de commande (Igl, Ig2, Ig3) sont réglées au moyen d'une source (2.4) pilotée par le régulateur (2.1), qui fonctionne dans un mode source de courant, la source (2.4) étant commutée du mode source de courant à un mode source de tension à la fin de la séquence de passage à l'état passant et/ou de la séquence de passage à l'état non passant.

13. Procédé selon la revendication 12,
**caractérisé en ce que** la fin de la séquence de passage à l'état passant et/ou la séquence de passage à l'état non passant est détectée au moyen
- d'un temporisateur déclenché au début du plateau Miller (MP), ou
- d'un comparateur de tension grille-source (V_{GS}).
